# EUROPEAN PATENT APPLICATION

(11) **EP 3 153 958 A1**
(43) Date of publication of application: **12.04.2017**
(21) Application number: 14893806.1
(22) Date of filing: 16.10.2014
(51) Int. Cl.: G06F 3/044

(54) **SELF-CAPACITANCE TOUCH DETECTION CIRCUIT**

(30) Priority: 06.06.2014 CN 201410250172
(71) Applicant: Shenzhen Huiding Technology Co., Ltd., Shenzhen, Guangdong 518000 (CN)
(72) Inventor: CHAO, Kuohao, Shenzhen Guangdong 518000 (CN); YANG, Fuchiang, Shenzhen Guangdong 518000 (CN); YANG, Mengta, Shenzhen Guangdong 518000 (CN)
(74) Representative: Valea AB
(86) International application number: PCT/CN2014/088718
(87) International publication number: WO 2015/184721

(57) **Abstract**

The present invention discloses a self-capacitance touch detection circuit, comprising a signal generator, a first amplifier, an offset signal generator and an analog-to-digital converter; wherein the signal generator generates a driving signal and then is divided into a first output branch and a second output branch, the first output branch being connected to the offset signal generator, a signal passing through an offset circuit being output to a first input terminal of the amplifier, and the second output branch being respectively connected to a touch panel and a second input terminal of the amplifier; the amplifier outputs a signal to the analog-to-digital converter; and the analog-to-digital converter converts the signal into a digital signal and sends the digital signal to a master control. In the self-capacitance touch detection circuit according to the present invention, with an offset signal generator being configured between the signal generator and the amplifier, the amplification factor of the amplifier is increased and the anti-interference capability of the detection circuit is improved.

## Description

### TECHNICAL FIELD

The present invention relates to the technical field of circuits, and in particular, relates to a self-capacitance touch detection circuit for use in a capacitive touch screen.

### BACKGROUND

Conventional capacitive touch screens/keys mainly employ self-capacitance detection touch input and mutual-capacitance detection touch input. With the self-capacitance detection technology, one terminal of a capacitor is grounded, and signals are sent and received from the other terminal of the capacitor to thus detect variations of the capacitance, thereby identifying whether there is a touch input. Detecting variations of a single self-capacitance only needs one 10 port, and thus fewer 10 ports are required. In addition, such touch screens may be practiced and manufactured by using a single layer of conductive material, which greatly saves the manufacture cost of the screens. With the mutual-capacitance detection technology, signals are sent from one terminal of a capacitor and are received from the other terminal of the capacitor to thus detect variations of the capacitance, thereby identifying whether there is a touch input. Therefore, detecting variations of a single mutual-capacitance needs two 10 ports, and thus relatively more 10 ports are required. In addition, such touch screens may be practiced and manufactured by using two layers of conductive materials, which relatively increases the manufacture cost of the screens.

There are a plurality of detection methods available in the conventional self-capacitance detection technology. Some detection methods are based on the relaxation oscillation principle, and convert the capacitance into a frequency or cycle-based signal for measurement. Some detection methods are based on charging and discharging of the resistors and capacitors, and measure the capacitance by performing single-slope or double-slope integral counting. Still some detection methods measure the capacitance by adjusting the charging and discharging currents of the capacitor based on successive approximation. These self-capacitance detection methods are subjected to a common defect, that is, weak capabilities resistant to the environmental interference. Particularly with respect to touch screens equipped on mobile phones, interference from both LCDs and mobile phone radio frequency signals. In the conventional self-capacitance detection methods, the signal-to-noise ratio of the touch signals implemented is not very high, generally below 30:1. This may result in that the resolution of the touch screen is low and the touch detection is simply subjected to mis-actions or the like.

### SUMMARY

The present invention is intended to provide a self-capacitance touch detection circuit. With an offset signal generator being configured, the amplification factor of the amplifier is increased and the anti-interference capability of the detection circuit is improved.

The present invention is practiced by a self-capacitance touch detection circuit, comprising a signal generator, a first amplifier, an offset signal generator and an analog-to-digital converter; wherein the signal generator generates a driving signal and then is divided into a first output branch and a second output branch, the first output branch being connected to the offset signal generator, a signal passing through an offset circuit being output to a first input terminal of the amplifier, and the second output branch being respectively connected to a touch panel and a second input terminal of the amplifier; the amplifier outputs a signal to the analog-to-digital converter; and the analog-to-digital converter converts the signal into a digital signal and sends the digital signal to a master control.

In one embodiment, the signal generator comprises a sinusoidal wave generator and a digital-to-analog converter, wherein the sinusoidal wave generator generates a sinusoidal wave signal, and the digital-to-analog converter converts the sinusoidal wave signal into an analog signal.

In one embodiment, the offset signal generator comprises a first resistor, a second resistor and a first capacitor; wherein one terminal of the first resistor is connected to the first output branch and the other terminal of the first resistor is connected to the first input terminal of the amplifier, one terminal of the first capacitor is grounded and the other terminal of the first capacitor is connected to one terminal of the second resistor, and the other terminal of the second resistor is connected to the first input terminal of the amplifier.

Preferably, the first resistor and the second resistor are variable resistors, and the first capacitor is a variable capacitor.

In one embodiment, a second amplifier is further connected between the offset signal generator and the first input terminal of the amplifier.

In one embodiment, the self-capacitance touch detection circuit further comprises a filter, wherein the filter is connected between the first amplifier and the analog-to-digital converter.

In one embodiment, the self-capacitance touch detection circuit further comprises a third resistor, wherein the third resistor is connected between the signal generator and the second input terminal of the amplifier.

Preferably, the third resistor is a variable resistor.

Preferably, the amplifier is a programmable gain amplifier.

Preferably, the filter is an anti-aliasing filter.

In the self-capacitance touch detection circuit according to the present invention, with an offset signal generator being configured between the signal generator and the amplifier, the amplification factor of the amplifier is increased and the anti-interference capability of the detection circuit is improved.

### BRIEF DESCRIPTION OF THE DRAWINGS

FIG. 1 is a block diagram illustrating principles of a self-capacitance touch detection circuit according to one embodiment of the present invention;
FIG. 2 is a block diagram illustrating principles of a self-capacitance touch detection circuit according to another embodiment of the present invention;
FIG. 3 is a block diagram illustrating principles of an equivalent circuit between a self-capacitance touch detection circuit and a touch panel in FIG. 1; and
FIG. 4 is a block diagram illustrating principles of an offset signal generator according to one embodiment of the present invention.

### DETAILED DESCRIPTION

To make the objective, technical solution, and advantages of the present invention clearer, the following section describes the technical solutions of the present invention in combination with the accompanying drawings and embodiments. It should be understood that the embodiments described here are only exemplary ones for illustrating the present invention, and are not intended to limit the present invention.

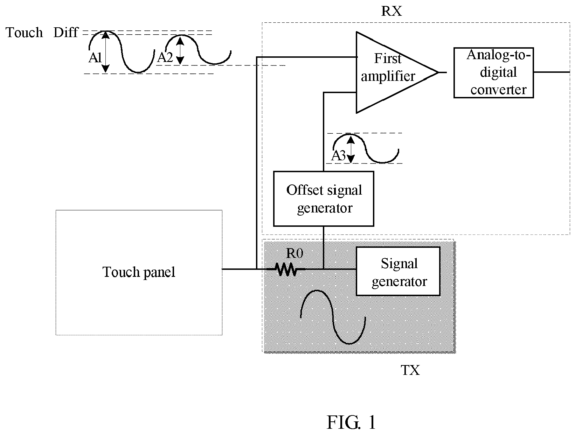

As illustrated in FIG. 1, a self-capacitance touch detection circuit comprises a signal generator, an amplifier, an offset signal generator, a filter and an analog-to-digital converter; wherein the signal generator generates a driving signal and then is divided into a first output branch and a second output branch, the first output branch being connected to the offset signal generator, a signal passing through an offset circuit being output to a first input terminal of the amplifier, and the second output branch being respectively connected to a touch panel and a second input terminal of the amplifier; the amplifier outputs a signal to the analog-to-digital converter; and the analog-to-digital converter converts the signal into a digital signal and sends the digital signal to a master control. Preferably, in this embodiment, the amplifier is a programmable gain amplifier (PGA), and the filter is an anti-aliasing filter. Preferably, the first input terminal is an inverse-phase input terminal, and the second input terminal is an in-phase input terminal.

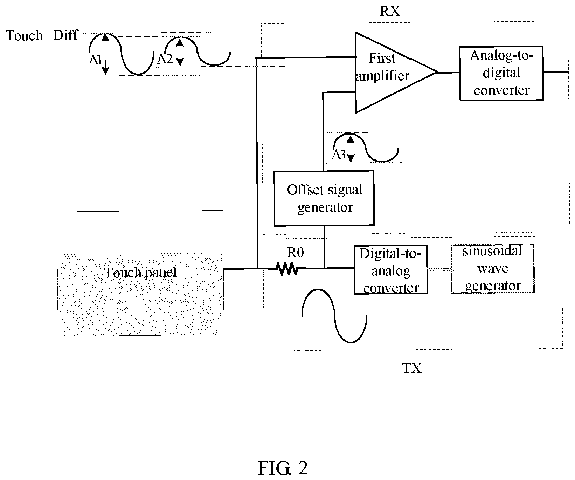

As illustrated in FIG. 2, in one embodiment of the present invention, the signal generator comprises a sinusoidal wave generator and a digital-to-analog converter, wherein the sinusoidal wave generator generates a sinusoidal wave signal, and the digital-to-analog converter converts the sinusoidal wave signal into an analog signal. A driving end TX outputs a sinusoidal wave having a defined frequency, and the sinusoidal wave is sent to a sensing end RX after being attenuation by a touch panel and is meanwhile attenuated after passing through an offset signal generator (assume that an amplitude attenuation is A3). In the case of no offset signal generator, a digital circuit may parse out that the amplitude is A1, after touch by a finger, the amplitude becomes A2, and a touch difference = A1-A2. In the case of an offset signal generator, the digital circuit may parse out that the amplitude is A1-A3, after touch by a finger, the amplitude becomes A2-A3, and a touch difference = (A1-A3)-(A2-A3) = A1-A2. With respect to an amplifier, the size of an output signal is generally constant, and a subtraction is performed between the signal at the reference terminal and the signal at the input terminal, A1-A3. The size of the input signal of the digital-to-analog converter is greatly reduced from the original AlxPGA_gain to (A1-A3)xPGA_gain, which is equivalent to PGA_gain, or A1 may be increased. The requirement imposed by the circuit after the amplifier on the noise is reduced. In the meantime, the flicker noise of the digital-to-analog converter may also be greatly eliminated, thereby improving the anti-interference capability of the detection circuit.

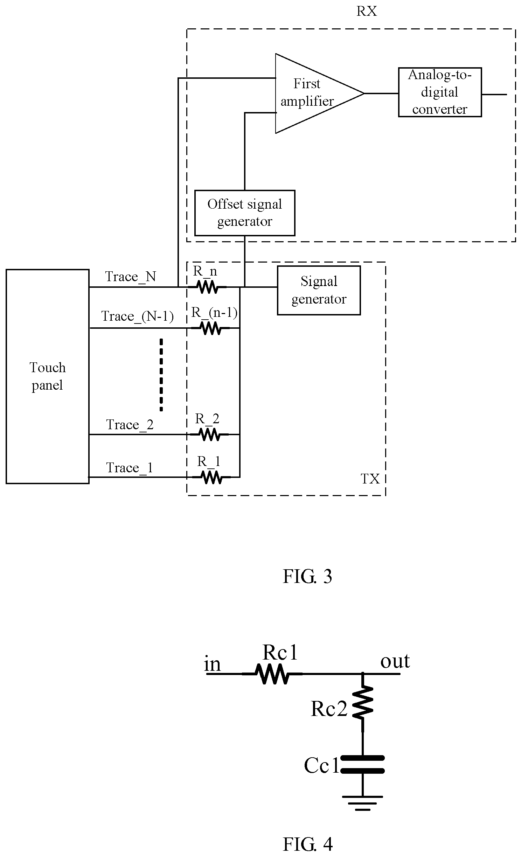

As illustrated in FIG. 4, in one embodiment of the present invention, the offset signal generator comprises a first resistor Rc1, a second resistor Rc2 and a first capacitor Cc1; wherein one terminal of the first resistor Rc1 is connected to the first output branch and the other terminal of the first resistor Rc1 is connected to the first input terminal of the amplifier, one terminal of the first capacitor Cc1 is grounded and the other terminal of the first capacitor Cc1 is connected to one terminal of the second resistor Rc2, and the other terminal of the second resistor Rc2 is connected to the first input terminal of the amplifier. Preferably, to accommodate different application scenarios, the first resistor Rc1 and the second resistor Rc2 may be both variable resistors, the resistances of which are defined according to the actual needs. Similarly, the first capacitor Cc1 is a variable capacitor, the capacitance of which is defined according to the actual needs.

Further, in one embodiment of the present invention, the self-capacitance touch detection circuit further comprises a third resistor Rc3, wherein the third resistor is connected between the signal generator and the second input terminal of the amplifier. Preferably, the third resistor is a variable resistance, the resistance of which is defined according to the actual needs.

Described above are merely preferred embodiments of the present invention, but are not intended to limit the present invention. Any modification, equivalent replacement, or improvement made without departing from the spirit and principle of the present invention should fall within the protection scope of the present invention.

## Claims

1. A self-capacitance touch detection circuit, comprising a signal generator, a first amplifier, an offset signal generator and an analog-to-digital converter; wherein the signal generator generates a driving signal and then is divided into a first output branch and a second output branch, the first output branch being connected to the offset signal generator, a signal passing through an offset circuit being output to a first input terminal of the amplifier, and the second output branch being respectively connected to a touch panel and a second input terminal of the amplifier; the amplifier outputs a signal to the analog-to-digital converter; and the analog-to-digital converter converts the signal into a digital signal and sends the digital signal to a master control.

2. The self-capacitance touch detection circuit according to claim 1, wherein the signal generator comprises a sinusoidal wave generator and a digital-to-analog converter, wherein the sinusoidal wave generator generates a sinusoidal wave signal, and the digital-to-analog converter converts the sinusoidal wave signal into an analog signal.

3. The self-capacitance touch detection circuit according to claim 1, wherein the offset signal generator comprises a first resistor, a second resistor and a first capacitor; wherein one terminal of the first resistor is connected to the first output branch and the other terminal of the first resistor is connected to the first input terminal of the amplifier, one terminal of the first capacitor is grounded and the other terminal of the first capacitor is connected to one terminal of the second resistor, and the other terminal of the second resistor is connected to the first input terminal of the amplifier.

4. The self-capacitance touch detection circuit according to claim 3, wherein the first resistor and the second resistor are variable resistors, and the first capacitor is a variable capacitor.

5. The self-capacitance touch detection circuit according to claim 3, wherein a second amplifier is further connected between the offset signal generator and the first input terminal of the amplifier.

6. The self-capacitance touch detection circuit according to claim 1, further comprising a filter, wherein the filter is connected between the first amplifier and the analog-to-digital converter.

7. The self-capacitance touch detection circuit according to claim 1, further comprising a third resistor, wherein the third resistor is connected between the signal generator and the second input terminal of the amplifier.

8. The self-capacitance touch detection circuit according to claim 1, wherein the third resistor is a variable resistor.

9. The self-capacitance touch detection circuit according to claim 1, wherein the amplifier is a programmable gain amplifier.

10. The self-capacitance touch detection circuit according to claim 1, wherein the filter is an anti-aliasing filter.
